Europäisches Patentamt

(19) European Patent Office

Office européen des brevets

(11) Publication number: **0 208 522**
**B1**

(12) # EUROPEAN PATENT SPECIFICATION

(45) Date of publication of the patent specification:
07.02.90

(21) Application number: **86305202.3**

(22) Date of filing: **04.07.86**

(51) Int. Cl. $^5$: **G 01 N 24/08**

(54) Nuclear magnetic resonance system.

(30) Priority: **11.07.85 JP 151342/85**

(43) Date of publication of application:
**14.01.87 Bulletin 87/03**

(45) Publication of the grant of the patent:
**07.02.90 Bulletin 90/06**

(84) Designated Contracting States:
**DE FR NL**

(56) References cited:
**EP-A-0 091 008**
**EP-A-0 145 932**
**WO-A-81/02788**
**WO-A-81/02789**

IEEE TRANSACTIONS ON MEDICAL IMAGING, vol. MI-3, no. 1, March 1984, pages 41-46, New York, US; H. IWAOKA et al.: " A new pulse sequence for "fast recovery" fast-scan NMR imaging"

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Machida, Yoshio c/o Patent Division**
**Toshiba Corp. Principal Off. 1-1, Shibaura 1-chome**
**Minato-ku Tokyo (JP)**
Inventor: **Kasugai, Takao c/o Patent Division**
**Toshiba Corp. Principal Off. 1-1, Shibaura 1-chome**
**Minato-ku Tokyo (JP)**

(74) Representative: **Shindler, Nigel**
**BATCHELLOR, KIRK & EYLES 2 Pear Tree Court**
**Farringdon Road**
**London EC1R 0DS (GB)**

## Description

The present invention relates to systems for providing, by nuclear magnetic resonance, images of distributions of a chosen quantity in a selected region of a body. The examination may be of many different kinds of bodies but a particularly beneficial application, to which much attention has been given, is medical examination of patients.

For NMR examination, suitable combinations of magnetic fields are applied to the body to be examined by appropriate magnet (coil) systems. Excited material is then detected by currents induced in one or more detector coil systems which are analysed to provide the required distribution.

Various schemes have been proposed for this purpose, two of which are relevant to this invention being that proposed by Edelstein and Hutchison et al in "Physics in Medicine & Biology" 25, 751 - 756 (1980) and that invented by Ernst and described in U.S. Patent No. 4 070 611.

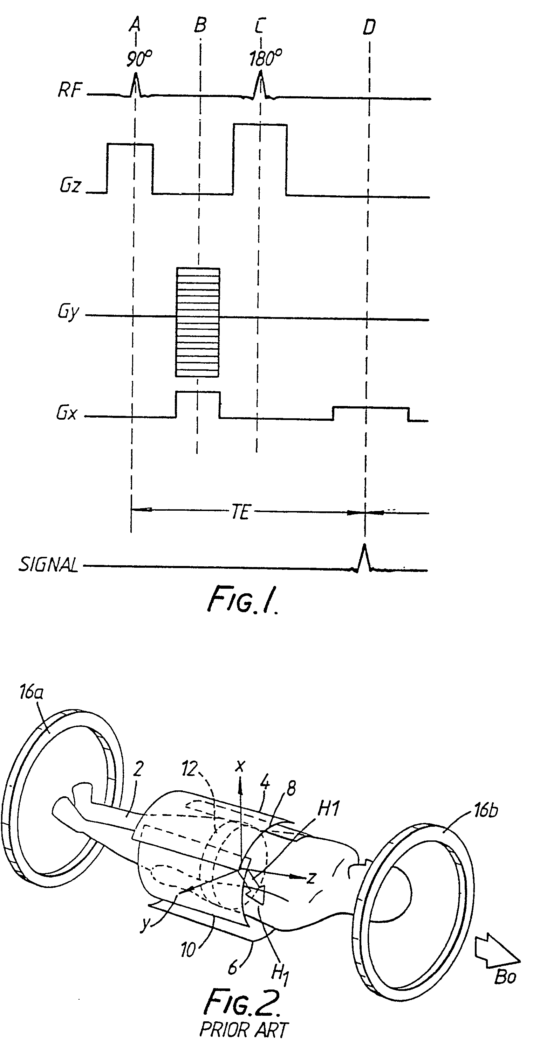

The imaging sequence used for the spin warp NMR imaging proposed by Edelstein et al shown in Figure 1 produces spin-echo images with transaxial orientation. The sequence begins when a sinc-modulated 90° nutation pulse (A) occurs simultaneously with a $G_z$ gradient pulse to produce the spatially selective excitation of nuclear spins. Three gradient pulses (B) are applied; $G_y$ phase encodes in-plane resolution, $G_z$ phase encodes image section, and $G_x$ defocuses the free induction decay (FID) to temporarily centre the later occurring spin-echo signal. A sinc-modulated 180° RF pulse (C) occurs simultaneously with a $G_z$ gradient pulse to produce echo refocusing. A read-out gradient $G_x$ frequency encodes (D) the spin-echo signal for resolution along an inplane axis. The 2 D images were made by iteration of the pulse sequence each time with a different magnitude of $G_y$ at (B).

Each of the above described cycles of the pulse sequence can be repeated several times (N) for signal averaging and to cancel FID artifacts which are produced by FID signal active during the spin-echo but generated by the 90° irradiation of the planar region outside the inner volume. To produce sagittal images, all the gradient pulses $G_z$ and $G_x$ are interchanged.

It should be appreciated that the above described techniques are disadvantageous in various aspects. For example, in the spin warp NMR imaging or Fourier zeugmatography known from U.S. Patent No. 4 070 611 two phase encoding magnetic gradients must be varied linearly in the respective directions so as to obtain the image information depending upon the linear variation between the intensity of the magnetic fields and the corresponding coordinates. However, in practice, the linearity depends on various instrumental parameters, such as quality of the coil, the power supply for the coil, etc. Therefore, the intensity of the gradient fields does not vary in a linear manner around the original which is the point in which the gradient contributes to the external field. This unavoidable nonlinearity of the gradient causes artifacts in the reconstructed NMR images.

It is an object of this invention to provide an improved method for producing nuclear magnetic resonance image data.

More specifically, an object of the present invention is to provide a method which eliminates those artifacts due to the above described non-linearity in the gradient, and includes a correction factor to correct variation of the intensity of the magnetic gradient along one axis prior to collection of the signals required for forming an image of magnetisation distribution using the Fourier zeugmatography technique.

According to the invention, prior to collecting an echo resonance signal produced by the 180° pulse, when the so-called spinecho technique is used, which is subject to 2 D Fourier transformation to obtain an image of the magnetisation distribution in the selected slice, a preliminary modulated phase encoding gradient field is applied, so that several preliminary and reference echo signals are obtained by sampling operations being performed in the presence of the preliminary gradient magnetic fields. Then, the intensity of the gradient with reference to the obtained signal is used to start a phase encoding gradient pulse sequence therewith for collecting the echo signals actually used for forming the desired imaging.

One embodiment of the invention will now be described by way of example with reference to the accompanying drawings, in which:

Figure 1   shows the pulse sequence of a spin warp NMR imaging method;

Figure 2   diagrammatically illustrates the arrangement of a target within the magnetic field generating coils;

Figure 3   shows schematically an apparatus which can be used to implement the invention;

Figure 4   shows the pulse sequence and spin-echo signals provided by the method of this invention; and

Figure 5   shows the relationship between the practical amplitude of the phase-encoding gradient, and range of amplitude of the gradient used in accordance with this invention.

Referring to Figure 2, a target or object to be investigated is placed in a static magnetic field $B_o$ which extends in the Z-direction. RF transmitter coils 4 and 6 and RF receiver coils 8 and 10 are shown, for example, to consist of two separate coil sets that are electrically orthogonal to one another and which generate RF magnetic field pulses having the required modulation to excite resonance in a planar slice 12 of the object defined by the combination of the application of the magnetic field gradient $G_z$ along the Z-direction produced by Z-axis gradient coils 16a and 16b and application of the corresponding RF magnetic field. RF magnetic field pulses are di-

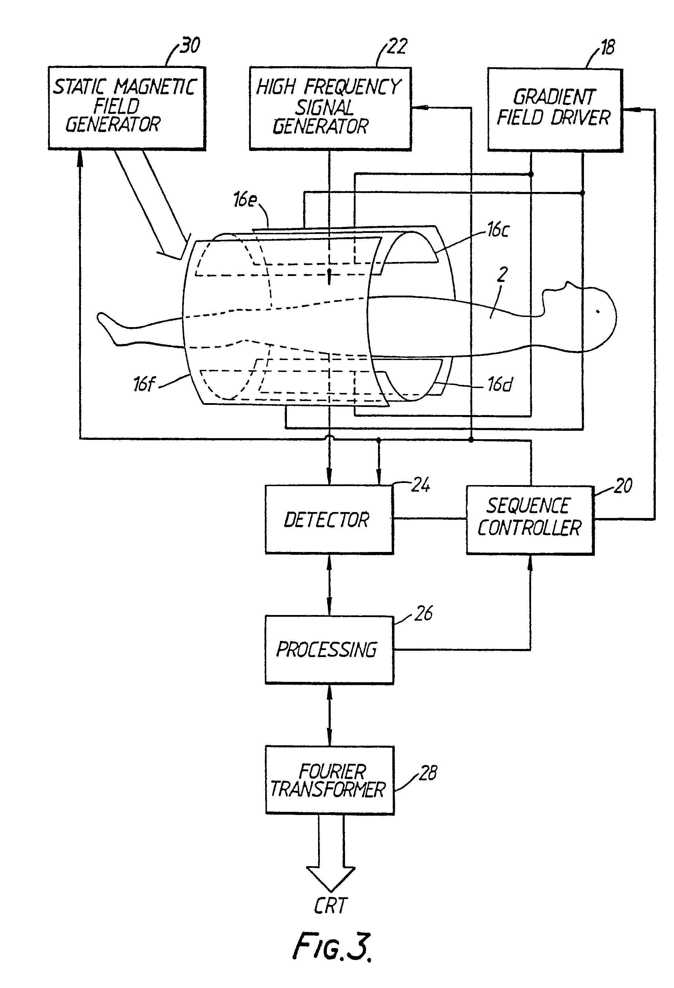

rected orthogonal to the $B_0$ field. The Z-axis gradient coils 16a and 16b are in the form of a Helmholtz pair wound in opposition, and are disposed substantially in planes perpendicular to the Z axis. In addition to $G_z$ gradient coils 16a and 16b, another two gradient coil sets are necessary to provide gradient $G_x$, and $G_y$, respectively for encoding the phase of the spin echo signals for image reconstruction to spatially resolve information along each axis. For the sake of clarity, the known arrangement of $G_x$ and $G_y$ gradient coil sets is only shown schematically as 16c, 16d, 16e, and 16f respectively in Figure 3, but is shown,in more detail for example, in U.S. Patent 4 355 282.

Figure 3 shows an apparatus for performing NMR detection in accordance with one embodiment of the invention. The apparatus comprises coils 16c, 16d, 16e, and 16f gradient field driver 18 for the sexcitation of the coils 16a, 16b, 16c, 16d, 16e and 16f, respectively, under the control of sequence controller 20, and a high-frequency signal generator 22 for the excitation of the coils 4, 6. The apparatus also comprises a high-frequency signal detector 24, processing means 26 including a sample circuit, an analogue-to-digital converter, a memory, and a Fourier transformer for performing a Fourier transformation. The static magnetic field $B_0$ which has already been described with reference to Figure 2 is generated by a static magnetic field generator 30 including appropriate coils and electrically connected driver. Though only the $G_x$, $G_y$ gradient coils 16c, 16d, 16e, and 16f are illustrated schematically in Figure 3, the $G_x$ coils 16c and 16d, and the $G_y$ coils 16e and 16f are two sets of coils axially displaced, each set comprising two pairs of saddle coils the pair (16c, 16d) being at 90° to the pair (16e, 16f). These coils are themselves inserted into the central aperture in $B_0$ coils (not shown in Figures). RF coil sets 4, 6, 8 and 10 are two of saddle shaped coils which are driven in parallel, to provide the rotating RF field by the highfrequency signal generator 22, and also to detect the echo resonance signals, which are of approximately the same frequency, by the highfrequency signal detector 24.

The apparatus performs a method for determining the nuclear magnetisation distribution in a body 2 as will be described hereinafter. The method comprises several steps.

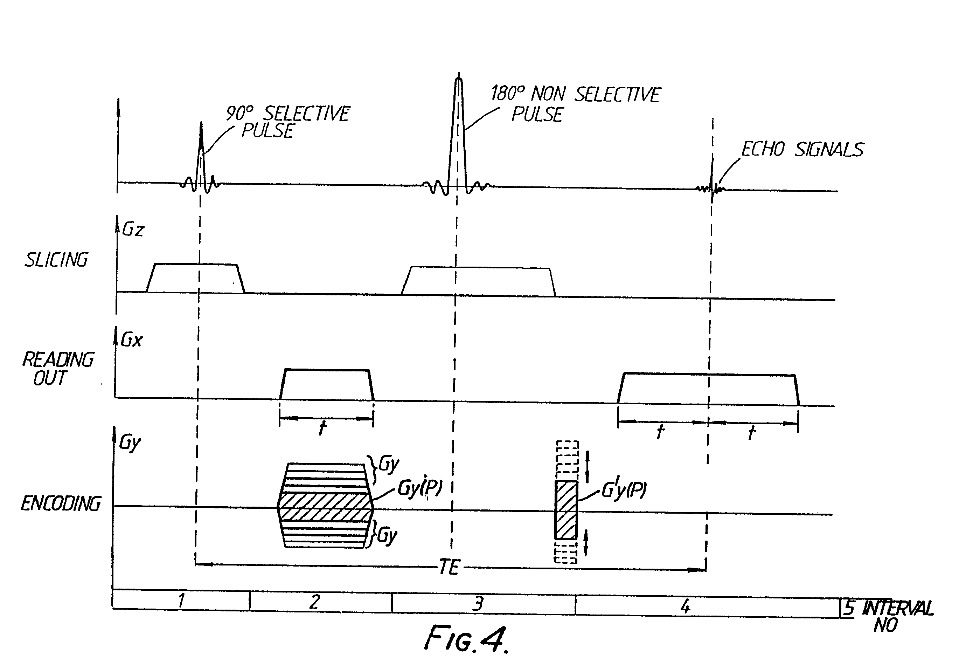

The pulse sequence used to form an image from single spin echos following separate excitations is shown in Figure 4.

## Interval 1

A selective 90° RF pulse is applied simultaneously with a magnetic field gradient $G_z$. This selectively excites nuclear spins in and close to the plane $Z = Z_0$. The value of $Z_0$ can be altered by a change in the frequency of the 90° pulse.

## Interval 2

A gradient of the magnetic field having a positive value $G_x$ is applied to dephase the nuclear spins along the X-direction. Simultaneously a smaller signal gradient $G_y(p)$ of the magnetic field is applied to dephase the spins along Y as a preliminary prior to collection of the resonance signals used for forming an image.

## Interval 3

A 180° RF pulse is applied simultaneously with a longer $G_z$ gradient pulse to produce echo refocusing. During a part of the period after the 180° pulse, a magnetic field gradient $G_y'(p)$ having corresponding values of time integral of the gradient $G_y(p)$ applied before the 180° pulse is applied.

## Interval 4

The echo signal is measured and sampled in the presence of a readout gradient $G_x$ which is applied to cause the spins to rephase and produce a kind of gradient-induced spin echo in the middle of the signal acquisition interval. The Fourier transform of this spin echo signal is therefore a one-dimensional projection of the spin density within the slice on the the X axis.

The entire set of steps described above is successively repeated a number of times and in each repetition a different amplitude of gradient $G_y'(p)$ is utilised to cause the signal to reach a peak value, of which amplitude represents the designated (nominal) phase encoding of the signal to spatially resolve information along the Y axis.

## Interval 5

System recovery time until the occurrence of interval 1 of the next sequence. This should be long compared with the spin-lattice relaxation time T and may be of the order of a second in a wholebody imaging apparatus.

The same procedures are performed to the reversed magnetic gradients $G_y(p)$ and $G_y'(p)$.

The resultant gradient $G_y(p)$ max serves to give a desired amount of twist or "warp" to each vertical column of spins (Y axis vertical) defined by the presence of the gradient $G_x$. In fact it maximises the response to a particular vertical spatial frequency in the column equal to the spatial frequency of the "warp".

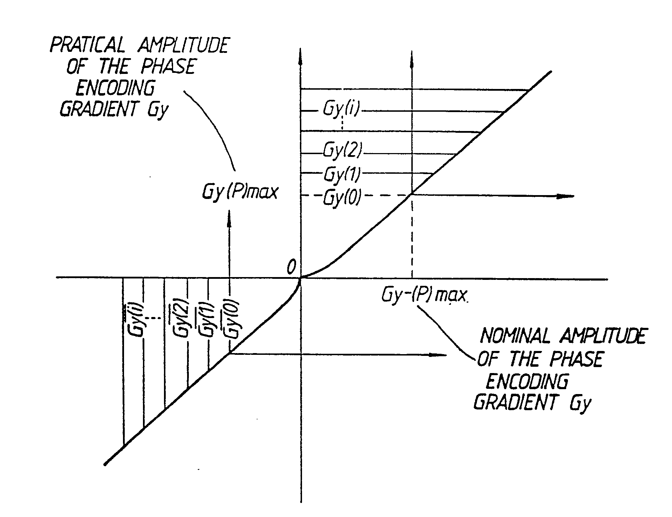

After the above described preliminary step, in Figures 4 and 5 the phase-encoding gradient $G_y$ is always applied for the same period of time but changes in strength for different pulse sequences. In each successive sequence $G_y$ has the same shape and length but its amplitude changes by equal steps from an imaginary zero, where the effect of two phase encoding gradients $G_y(p)$ and $G_y'(p)$ is cancelled in phase of the echo signal, to a maximum value.

In accordance with the proposed method, a range of vertical frequencies from zero up to a maximum is a linear function of $G_y$ linear phase-encoding gradient strengths starting with the value of $G_y'(p)$ max by avoiding the non-linear scale of phase-encoding gradient.

The two-dimensional (2D) Fourier transform image is produced by iteration of the pulse sequence each time with a different magnitude of $G_y$.

In order to achieve this object of applying $G_y$ linear phaseencoding gradient strengths starting with the point where the phase of the encoded spin-echo signal is of imaginary zero by the combination of application of preliminary gradients $G_y(p)$ before and after 180° RF pulse, the spin-echo signals are detected by the high-frequency detector 24 in order of changing $G_y'(p)$ pulse strength generated by $G_y$ coils 16c and 16f under control of sequence controller 20. Then, in processing means (26 in Figure 3) the time integral value of $G_y'(p)$ gradient is determined, which maximises the signal that is eventually obtained. Information on this value of the phase-encoding gradient is provided to the sequence controller 20 to follow the primary image data acquisition steps with application of different $G_y$ linear phaseencoding gradients from the offset magnetic field that has been previously obtained.

## Claim

Method of deriving image information from an object using nuclear magnetic resonance signals comprising subjecting said object to a static magnetic field along an axis and carrying out a set of sequential preliminary steps which comprises:

- selectively exciting nuclear spins in a selected plane in the presence of a first gradient magnetic field ($G_z$) applied in a first direction;
- applying a second gradient magnetic field for ($G_x$) in a second direction encoding the phase of the selected spins to spatially resolve information along one axis which is orthogonal to said first direction;
- applying a preliminary third gradient magnetic field ($G_y$) in a third direction orthogonal to said first and second directions for preliminary phase encoding along said third direction;
- applying a 180° RF pulse associated with a gradient applied in the first direction to produce echo refocussing;
- applying an additional preliminary third gradient ($G_y'(p)$) after said 180° RF pulse having a designated strength which is substantially identical to that of said preceding preliminary third gradient ($G_y$);
- removing the additional third gradient ($G_y'(p)$) and reading out the resultant spin echo signal from the object in the presence of a read-out gradient applied in the second direction; and then

- successively repeating the above set of sequential steps with a different value of integral of said additional preliminary third gradient ($G_y'(p)$) applied after the 180° RF pulse in order to calculate on the basis of a processing of resultant spin echo signals an intensity of the phaseencoding gradient in the third direction preserving its linearity and then successively repeating the above set of sequential steps with intensities of the preliminary third gradient replaced by different linear phase-encoding gradient intensities starting with said obtained intensity to obtain a group of sampled signals wherefrom, after Fourier transformation thereof, an image of the distribution of the spin magnetisation is determined.

## Patentanspruch

Verfahren zur Gewinnung von Bildinformationen eines Objektes aus magnetischen Kernresonanzsignalen, indem das Objekt einem statischen Magnetfeld entlang einer Achse ausgesetzt wird und eine Reihe von aufeinanderfolgenden vorbereitenden Schritten durchgeführt werden, die folgende Schritte umfassen:

- Selektive Erregung von Kernspins in einer ausgewählten Ebene bei Vorhandensein eines ersten, in einer ersten Richtung angelegten Magnetfeldgradienten ($G_z$);
- Anlegen eines zweiten Magnetfeldgradienten ($G_z$) in einer zweiten Richtung zum Kodieren der Phase der ausgewählten Spins, um die Information räumlich aufzulösen entlang einer Achse, die orthogonal zur ersten Richtung verläuft;
- Anlegen eines vorbereitenden dritten Magnetfeldgradienten ($G_y$) in einer dritten Richtung, die orthogonal zur ersten und zweiten Richtung verläuft, zur vorbereitenden Phasenkodierung entlang der dritten Richtung;
- Anlegen eines 180° Hochfrequenzimpulses, der einem in der ersten Richtung angelegten Gradienten zugeordnet ist, um eine Echo-Refokussierung zu erzeugen;
- Anlegen eines zusätzlichen vorbereitenden dritten Gradienten ($G_y'(p)$) nach Anlegen des 180° Hochfrequenzimpulses, mit einer bestimmten Stärke, die im wesentlichen gleich ist derjenigen des vorhergehenden, vorbereitenden dritten Gradienten ($G_y$);
- Beseitigung des zusätzlichen dritten Gradienten ($G_y'(p)$) und Auslesen des resultierenden Spin-Echo-Signales aus dem Objekt bei Vorhandensein eines in der zweiten Richtung angelegten Auslese-Gradienten; und
- Wiederholung der Reihe nach des oberen Satzes aufeinanderfolgender Schritte mit einem Integralwert des zusätzlichen nach dem 180° Hochfrequenzimpuls angelegten Gradienten (G'y(p)), um auf der Grundlage einer resultierenden Spin-Echo-Signalverarbeitung eine Intensität des phasenkodierenden Gradienten in der dritten, seine Linearität erhaltenden Richtung zu berechnen, und dann aufeinanderfolgende Wiederholung des oberen Satzes aufeinanderfolgender Schritte, wobei die Intensitäten des vorbereitenden dritten Gradienten ersetzt sind durch unterschiedliche lineare phasenkodierende Gradienten-Intensitäten, indem mit der erhaltenen Intensität begonnen wird, um eine Gruppe von abgetasteten Signalen zu erhalten, aus der nach Fourier-Transformation ein Verteilungsbild der Spin-Magnetisierung ermittelt wird.

**Revendication**

Un procédé destiné à obtenir des informations d'images à partir d'un objet en utilisant des signaux de résonance magnétique nucléaire, en soumettant ledit objet à un champ magnétique statique le long d'un axe et en effectuant un ensemble d'étapes préliminaires séquentielles qui consistent :

- à exciter de façon sélective des spins nucléaires dans un plan choisi en présence d'un premier champ magnétique de gradient $G_z$ appliqué dans une première direction;
- à appliquer un second champ magnétique de gradient $G_x$ dans une seconde direction pour coder la phase des spins choisis afin de traduire des informations dans l'espace le long d'un axe qui est orthogonal à ladite première direction;
- à appliquer un troisième champ magnétique de gradient préliminaire $G_y$ dans une troisième direction orthogonale auxdites première et seconde directions pour un codage en phase préliminaire le long de ladite troisième direction;
- à appliquer une impulsion à haute fréquence à 180° associée à un gradient appliqué à la première direction pour produire une refocalisation d'écho;
- appliquer un troisième gradient préliminaire supplémentaire (G'y(p)) après ladite impulsion à haute fréquence à 180°, ayant une intensité définie qui est sensiblement identique à celle du-dit troisième gradient précédent préliminaire (Gy);
- à supprimer le troisième gradient préliminaire (G'y(p)) et à extraire le signal d'écho de spin résultant à partir de l'objet en présence d'un gradient extrait appliqué dans une seconde direction; puis,
- à répéter successivement l'ensemble ci-dessus d'étapes séquentielles avec une valeur différente d'intégrale du-dit troisième gradient préliminaire supplémentaire (G'y(p)) appliqué après l'impulsion à haute fréquence à 180° en vue de calculer sur la base d'un traitement de signaux de spins résultant, une intensité du gradient de codage de phase dans la troisième direction en préservant sa linéarité, puis à répéter successivement l'ensemble ci-dessus d'étapes séquentielles avec des intensités du troisième gradient préliminaire remplacées par différentes intensités de gradients de codage de phase linéaires en commençant par ladite intensité obtenue, afin d'obtenir un groupe de signaux échantillonnés, à partir desquels, et après leur transformation par une transformée de Fourier, on détermine la répartition de la magnétisation du spin.

FIG. 1.

FIG. 2.
PRIOR ART

1

FIG.3.

FIG.4.

90° SELECTIVE PULSE

180° NON SELECTIVE PULSE

ECHO SIGNALS

SLICING

READING OUT

ENCODING

Gz

Gx

Gy

}Gy

Gy(P)

}Gy

G'y(P)

TE

t

t

t

1     2     3     4     5 INTERVAL NO

EP 0 208 522 B1

PRATICAL AMPLITUDE
OF THE PHASE
ENCODING
GRADIENT Gy

Gy(i)

Gy(2)

Gy(1)

Gy(0)

Gy(P)max

0

Gy(i)

Gy(2)

Gy(1)

Gy(0)

Gy-(P)max

NOMINAL AMPLITUDE
OF THE PHASE
ENCODING
GRADIENT Gy

7